# FASCICULE DE BREVET EUROPEEN

(11) **EP 2 293 443 B1**
(45) Date de publication et mention de la délivrance du brevet: **03.06.2020**
(21) Numéro de dépôt: 10174556.0
(22) Date de dépôt: 30.08.2010
(51) Int. Cl.: H03K 17/082, H03K 17/16

(54) **Module électronique de commande pour transistor JFET**
Elektronisches Steuermodul für einen JFET Transistor
Electronic control module for a JFET transistor

(30) Priorité: 31.08.2009 FR 0955933
(43) Date de publication de la demande: 09.03.2011
(73) Titulaire: Safran Electrical & Power, 31702 Blagnac Cedex (FR)
(72) Inventeur: Rambaud, Julien, 77000 Melun (FR); Vieillard, Sébastien, 77720 La Chapelle Gauthier (FR)
(74) Mandataire: Lebkiri, Alexandre

(56) Documents cités:
- EP-A1- 1 557 560
- WO-A1-00/77933
- WO-A2-2009/009380
- US-A- 5 282 107
- US-A1- 2004 100 303
- US-A1- 2006 163 691
- US-B1- 6 614 281
- MIHAILA A ET AL: "A numerical comparison between MOS control and junction control high voltage devices in SiC technology" SOLID STATE ELECTRONICS, ELSEVIER SCIENCE PUBLISHERS, BARKING, GB LNKD- DOI:10.1016/S0038-1101(02)00185-5, vol. 47, no. 4, 1 avril 2003 (2003-04-01), pages 607-615, XP004408710 ISSN: 0038-1101

## Description

### DOMAINE TECHNIQUE DE L'INVENTION

La présente invention concerne un module électronique de commande pour transistor à effet de champ comprenant une grille, un drain et une source.

Elle trouve une application particulière dans le domaine des transistors à effet de champ.

### ARRIÈRE-PLAN TECHNOLOGIQUE DE L'INVENTION

Dans le domaine des transistors à effet de champ, un état de la technique connu de module électronique de commande comprend un transistor à effet de champ et un circuit de commande pour commander le transistor à effet de champ en faisant varier le potentiel de la grille du transistor par rapport au potentiel de sa source. Le circuit de commande est alimenté avec une tension négative car un transistor à effet de champ est commandé en tension négative.
Lorsque le transistor à effet de champ est dans un état passant, il y a des risques de court-circuit, ce qui peut entraîner sa destruction.
Il existe des méthodes qui permettent de détecter un court-circuit notamment en comparant la tension drain-source, dite tension de saturation du transistor, avec une tension de référence, ladite tension drain-source étant positive.
Lorsque la tension drain-source est supérieure à cette tension de référence, on en déduit que le transistor à effet de champ est en régime de sur-courant ou de court-circuit.
Un potentiel négatif est donc nécessaire pour commander le transistor à effet de champ en raison de la commande en tension négative et un potentiel positif est également nécessaire pour la comparaison avec la tension de saturation positive.

Un inconvénient de cet état de la technique est que l'on doit donc disposer d'une alimentation isolée électriquement supplémentaire pour la détection de court-circuit ce qui pose des problèmes de régulation d'alimentation supplémentaire. Cela ajoute un composant supplémentaire, l'alimentation supplémentaire, dans le module de commande dans le cas où la détection de court-circuit est effectuée en dehors du circuit de commande, et sinon complique le design du circuit de commande lui-même pour intégrer l'alimentation supplémentaire dans le cas où la détection de court-circuit est effectuée à l'intérieur même du circuit de commande.

Le document US 6 614 281 intitulé "Method and device for disconnecting a cascode circuit with voltage-controlled semiconductor switches", le document US 2004/0100303 intitulé "Three terminal noninverting transistor switch background of the invention", le document US 5 282 107 intitulé "Power MOSFET safe operating area current limiting device" et le document US 2006/163691 A1 intitulé « High voltage sensor device and method therefor » sont connus de l'état de l'art.

### DESCRIPTION GENERALE DE L'INVENTION

La présente invention a pour but un module électronique de commande selon la revendication indépendante 1.

Comme on va le voir en détail par la suite, le fait de commander le transistor à effet de champ avec sa source au lieu de sa grille va permettre d'avoir la tension drain-source du transistor à effet de champ référencée par rapport au potentiel fixe lorsque le transistor est dans un état passant, à savoir lorsqu'il est dans un état où il y a un risque de court-circuit. La tension drain-source comporte ainsi la même référence que la fonction de détection de court-circuit. On peut ainsi facilement comparer cette tension drain-source sans avoir d'alimentation supplémentaire.

Selon des modes de réalisation non limitatifs, le module électronique de commande peut comporter en outre une caractéristique supplémentaire suivante :
- Le circuit de commande comporte en outre un dispositif de décalage de niveau de tension. Cela permet ainsi d'utiliser un dispositif de commande alimenté entre un potentiel négatif et un potentiel positif couramment utilisé dans le domaine des transistors.

En outre, il est également proposé un actionneur électromécanique, caractérisé en ce qu'il comporte un module électronique de commande selon l'une quelconque des caractéristiques précédentes.

En outre, il est également proposé un inverseur de poussée électrique, caractérisé en ce qu'il comporte un module électronique de commande selon l'une quelconque des caractéristiques précédentes.

L'invention et ses différentes applications seront mieux comprises à la lecture de la description qui suit et à l'examen des Figs. qui l'accompagnent.

### BREVE DESCRIPTION DES FIGURES

Celles-ci ne sont présentées qu'à titre indicatif et nullement limitatif de l'invention.
- La Fig.1 est un schéma simplifié d'un module électronique de commande selon un exemple comportant un circuit de commande et un transistor à effet de champ ;
- La Fig. 2 est un schéma simplifié d'un exemple non limitatif d'un étage amplificateur du circuit de commande de la Fig. 1 ;
- La Fig.3 et la Fig. 4 sont des schémas simplifiés selon un premier exemple non limitatif du module électronique de commande de la Fig. 1 dans un premier et deuxième modes de fonctionnement respectivement, le circuit de commande dudit module électronique de commande étant alimenté avec une tension négative ;
- La Fig. 5 est un schéma simplifié du module électronique de commande de la Fig. 3 ou de la Fig. 4, dans lequel une fonction de détection de court-circuit est illustrée ;
- La Fig.6 et la Fig. 7 sont des schémas simplifiés selon l'invention du module électronique de commande de la Fig. 1 dans un premier et deuxième modes de fonctionnement respectivement, le circuit de commande dudit module électronique de commande étant alimenté avec une tension positive ;
- La Fig.8 et la Fig. 9 sont des schémas simplifiés selon un deuxième exemple non limitatif du module électronique de commande de la Fig. 1 dans un premier et deuxième modes de fonctionnement respectivement, le circuit de commande dudit module électronique de commande étant alimenté entre un potentiel positif et un potentiel négatif ;
- La Fig. 10 représente schématiquement un actionneur électromécanique comportant le module électronique de commande de la Fig. 1 ; et
- La Fig. 11 représente schématiquement un inverseur de poussée électrique comportant module électronique de commande de la Fig. 1.

### DESCRIPTION DE MODES DE REALISATION DE L'INVENTION

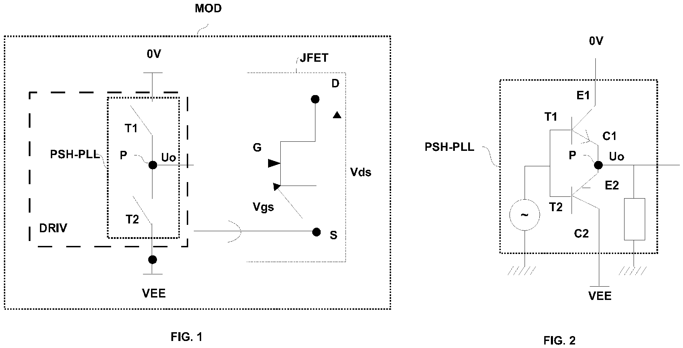

Le module électronique de commande MOD pour transistor à effet de champ JFET comprenant une grille G, un drain D et une source S est illustré schématiquement à la Fig. 1.
On notera que dans la suite de la description, on appellera également le transistor à effet de champ JFET indifféremment transistor JFET ou encore JFET.

Le module électronique de commande MOD comporte :
- un circuit de commande DRIV comportant :
   - une alimentation apte à fournir un potentiel fixe VEE à la grille G du transistor à effet de champ JFET ; et
   - un étage amplificateur PSH-PLL apte à faire varier le potentiel de la source S du transistor à effet de champ JFET par rapport au potentiel de la grille G dudit transistor à effet de champ JFET ; et
- un transistor à effet de champ JFET dont :
   - la grille G est connectée audit potentiel fixe VEE ; et
   - la source S est connectée audit étage amplificateur PSH-PLL.

Le circuit de commande DRIV permet donc de fixer la grille G du transistor JFET au potentiel fixe VEE pendant qu'il fait varier le potentiel de la source du transistor JFET.

On notera qu'on entend par potentiel fixe VEE, un potentiel qui ne varie pas notamment au cours de l'utilisation du transistor à effet de champ JFET, c'est-à-dire un potentiel qui est figé.

Dans un exemple non limitatif illustré de façon simplifié à la Fig. 2, l'étage amplificateur PHS-PLL du circuit de commande DRIV comporte au moins deux interrupteurs placés en série T1-T2 comprenant un point de jonction commun P apte à être couplé à la source S dudit transistor à effet de champ JFET, un des interrupteurs T2 dudit étage amplificateur étant apte à être couplé à la grille G dudit transistor à effet de champ JFET. Dans une variante de réalisation non limitative, le premier interrupteur T1 et le deuxième interrupteur T2 sont des transistors. Ainsi, l'étage amplificateur PHS-PLL comporte au moins deux transistors placés en série T1-T2 comprenant un point de jonction commun P anode-cathode apte à être couplé à la source S dudit transistor à effet de champ JFET, un des transistors T2 dudit étage amplificateur comprenant une électrode C2 apte à être couplée à la grille G dudit transistor à effet de champ JFET.
Dans un exemple non limitatif, le premier transistor T1 est un transistor bipolaire IGBT de type NPN et le deuxième transistor T2 est un transistor bipolaire IGBT de type PNP. Dans ce cas, l'anode du point de jonction P est le collecteur C1 du premier transistor T1 et la cathode du point de jonction P est l'émetteur E2 du deuxième transistor T2. De plus, l'électrode C2 apte à être couplée à la grille G du JFET est le collecteur du deuxième transistor bipolaire T2.
Dans cette variante de réalisation l'étage amplificateur PSH-PLL est un étage appelé « Push-Pull » en anglais. Un étage push-pull étant bien connu de l'homme du métier, il n'est pas décrit plus en détail.

Dans un mode de réalisation non limitatif, le potentiel fixe VEE est le potentiel le plus bas fourni par l'alimentation du driver DRIV.

Dans un premier exemple non limitatif du module électronique de commande MOD, le potentiel fixe VEE est un potentiel négatif VNEG et le circuit de commande DRIV comporte en outre un comparateur de tension CMP référencé avec ledit potentiel fixe VEE et apte à comparer la tension drain-source Vds dudit transistor à effet de champ JFET avec une tension de référence.

Dans le mode de réalisation de l'invention du module électronique de commande MOD, le circuit de commande DRIV comporte en outre un dispositif de commande DIGBT d'un transistor bipolaire à grille isolée IGBT et un inverseur de tension IN couplé audit dispositif de commande DIGBT.

Dans un deuxième exemple non limitatif du module électronique de commande MOD, le circuit de commande DRIV comporte en outre un dispositif de commande DIGBT d'un transistor bipolaire à grille isolée IGBT, un inverseur de tension IN couplé audit dispositif de commande DIGBT et un dispositif de décalage de niveau de tension DEN.

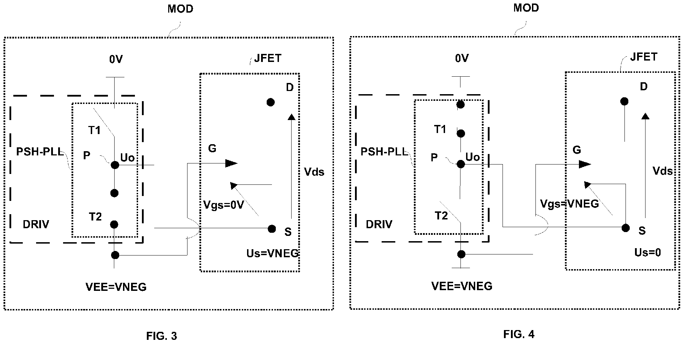

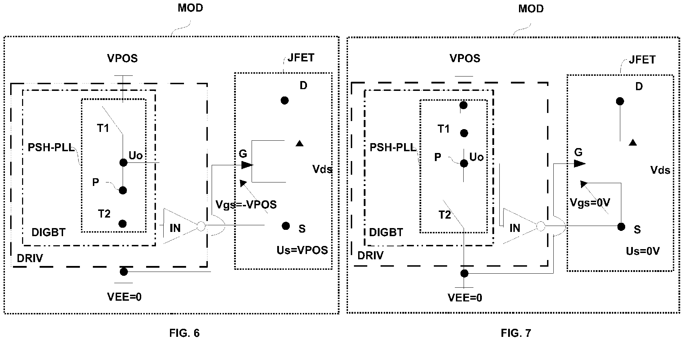

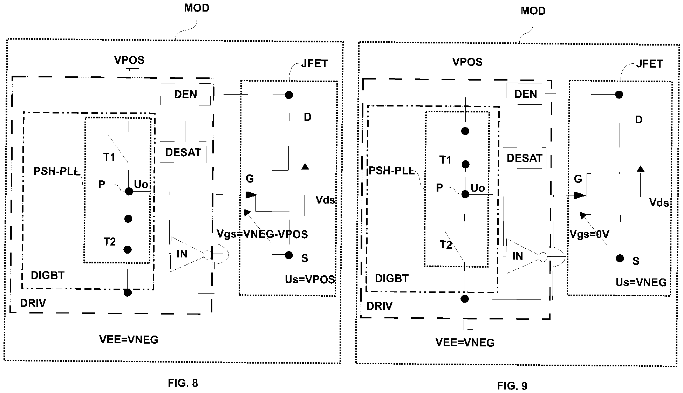

Le fonctionnement du module électronique de commande MOD selon deux exemples et un mode de réalisation ci-dessus est illustré respectivement dans trois exemples qui sont les suivants :
- lorsque le circuit de commande DRIV est alimenté avec une tension négative (Figs. 3 et 4) ;
- lorsque le circuit de commande DRIV est alimenté avec une tension positive (Figs. 6 et 7).
- Lorsque le circuit de commande DRIV est alimenté entre un potentiel négatif et un potentiel positif (Figs. 8 et 9).
On notera que de façon non limitative, dans les deux exemples et le mode de réalisation on fait varier le potentiel Us de la source S entre le potentiel le plus bas et le potentiel le plus haut fournis par l'alimentation du circuit de commande DRIV.

### Premier exemple: alimentation en tension négative

Comme illustré sur les Fig. 3 et Fig.4, le circuit de commande DRIV comporte une alimentation qui fourni une tension négative VNEG-OV. Dans un exemple non limitatif, le potentiel fixe VEE fourni par l'alimentation du circuit de commande DRIV à la grille G du transistor JFET est positionné au potentiel le plus bas, soit le potentiel VNEG fourni par l'alimentation. Le potentiel négatif alimente donc la grille du transistor JFET, soit Ug = VNEG.

Dans ce premier exemple, l'étage amplificateur PHS-PLL est apte :
- à positionner le potentiel de la source S à zéro pour bloquer ledit transistor à effet de champ JFET ; et
- à positionner le potentiel de la source S au potentiel fixe VEE pour rendre passant ledit transistor à effet de champ JFET.

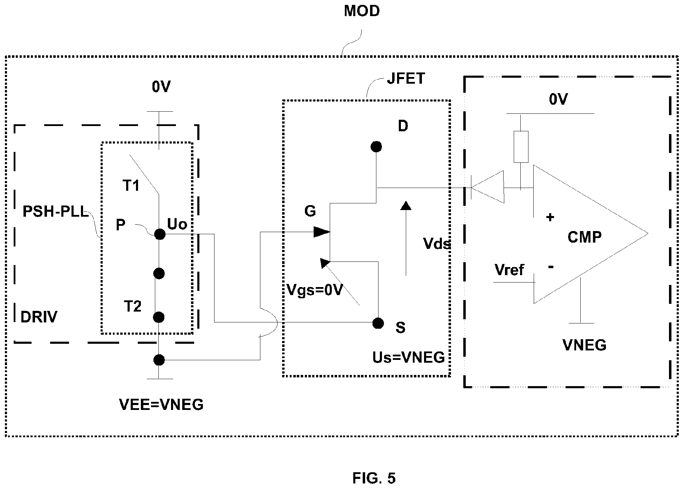

Selon un premier mode de fonctionnement tel qu'illustré sur la Fig. 3, lorsque le premier interrupteur T1 est ouvert, et le deuxième interrupteur T2 est fermé, on a le potentiel de jonction Uo au point de jonction P qui est porté au potentiel négatif VNEG. On obtient donc :
Us = VNEG;
Vsg = Us-Ug = 0; et
Vds=Ud-Us > 0 et est donc référencée par rapport au potentiel négatif VNEG car le potentiel Us de source S est porté au potentiel négatif VNEG.
On a donc la tension Vds qui est inférieure à VNEG en valeur absolue et qui est donc comprise dans l'intervalle de tensions fournies par l'alimentation [0 ; VNEG].
Le transistor JFET est dans un état passant.
Dans cet état passant, il y a des risques de court-circuit sur le transistor JFET. Un court-circuit peut arriver lorsque le transistor JFET se retrouve passant sur une source de tension. Dans ce cas, c'est le transistor seul qui limite le courant (ce dernier étant 5 à 10 fois plus élevé que le courant nominal) avec la pleine tension d'alimentation à ses bornes. De ce fait, le transistor JFET dissipe un niveau d'énergie très important, ce qui peut entraîner une élévation anormale de sa température et donc sa destruction si cette dissipation dure trop longtemps.
Afin de déterminer la présence d'un court-circuit, le circuit de commande DRIV comporte en outre, tel qu'illustré sur la Fig. 5, un comparateur de tension CMP référencé avec ledit potentiel fixe VEE=VNEG (car alimenté avec une tension d'alimentation négative VNEG-OV) et apte à comparer la tension drain-source Vds dudit transistor à effet de champ JFET avec une tension de référence. Si la tension Vds est supérieure à cette tension de référence, cela signifie que le transistor JFET est en court-circuit. On notera qu'il existe également une diode de protection et une résistance de polarisation entre le drain du transistor JFET et le comparateur de tension CMP comme illustré sur la Fig. 5. Ces deux éléments et leur fonction étant bien connus de l'homme du métier, ils ne sont pas décrits ici.
Comme la tension drain-source Vds est référencée par rapport au potentiel négatif VNEG, qui correspond au même potentiel de référence que celui du comparateur CMP, la comparaison peut se faire sans avoir d'alimentation supplémentaire.

Selon un deuxième mode de fonctionnement tel qu'illustré sur la Fig. 4, lorsque le premier interrupteur T1 est fermé, et le deuxième interrupteur T2 est ouvert, on a le potentiel de jonction Uo au point de jonction P qui est porté à 0V. On obtient donc :
Us = 0;
Vsg = Us-Ug = - VNEG > 0, soit Vgs = VNEG <0; et
Vds=Ud-Us > 0. La tension Vds sort alors de l'intervalle de tensions fournies par l'alimentation [0-VNEG].
Le transistor JFET est dans un état bloqué.

### Mode de réalisation de l'invention: Alimentation en tension positive

Dans ce mode d'alimentation, dans un mode de réalisation non limitatif, le circuit de commande DRIV comporte en outre un dispositif de commande DIGBT d'un transistor bipolaire à grille isolée IGBT et un inverseur de tension IN couplé audit dispositif de commande DIGBT.

Dans ce mode de réalisation, le dispositif de commande DIGBT comporte également l'étage amplificateur PSH-PLL tel que décrit précédemment.

Par ailleurs, on notera que les dispositifs de commande DIGBT d'un transistor bipolaire à grille isolée IGBT bien connus de l'homme du métier sont soit alimentés en tension positive 0V-VPOS, soit en tension comprise entre un potentiel négatif VNEG et un potentiel positif VPOS. Dans cet exemple, le dispositif de commande DIGBT est alimenté en tension positive 0V-VPOS.
Dans ce deuxième mode de réalisation, l'étage amplificateur PSH-PLL est apte à positionner le potentiel de la source S au potentiel fixe VEE pour rendre passant ledit transistor à effet de champ JFET.

Comme illustré sur les Fig. 6 et Fig.7, le circuit de commande DRIV est alimenté par une tension d'alimentation positive 0V-VPOS comprenant donc un potentiel positif VPOS, le circuit de commande étant ainsi placé entre la masse et le potentiel positif VPOS. Le potentiel fixe VEE fourni par l'alimentation du circuit de commande DRIV à la grille G du transistor JFET est positionné au potentiel le plus bas fourni par l'alimentation, qui est la masse. Le potentiel Ug de la grille G est donc mis à la masse, soit Ug = 0V.

On notera que l'inverseur de tension IN est également alimenté par la même tension d'alimentation positive 0V-VPOS que le circuit de commande DRIV. Par ailleurs, on rappelle que la fonction de l'inverseur IN permet d'inverser au niveau logique le signal d'entrée.

Selon un premier mode de fonctionnement tel qu'illustré sur la Fig. 6, lorsque le premier interrupteur T1 est ouvert, et le deuxième interrupteur T2 est fermé, on a le potentiel de jonction Uo au point de jonction P qui est tiré à la masse. On obtient donc :
Uo = VEE = 0V en entrée de l'inverseur IN, soit Us = VPOS en sortie de l'inverseur IN;
Vsg = Us-Ug = VPOS, soit Vgs = -VPOS < 0; et
Vds=Ud-Us > 0. La tension Vds sort de l'intervalle de tensions de l'alimentation [0-VPOS].
Le transistor JFET est dans un état bloqué.

Selon un deuxième mode de fonctionnement tel qu'illustré sur la Fig. 7, lorsque le premier interrupteur T1 est fermé, et le deuxième interrupteur T2 est ouvert, on a le potentiel de jonction Uo au point de jonction P qui est porté au potentiel positif VPOS. On obtient donc :
Uo = VPOS en entrée de l'inverseur IN, soit Us = 0V en sortie de l'inverseur IN;
Vsg = Us-Ug = 0V; et
Vds=Ud-Us > 0 et est donc référencé par rapport à la masse car le potentiel Us de la source S est à la masse.
On a donc la tension Vds inférieure à VPOS en valeur absolue et est donc comprise dans l'intervalle de tensions de l'alimentation [0 ; VPOS].
Le transistor JFET est dans un état passant.
Dans cet état passant, il y a des risques de court-circuit sur le transistor JFET, comme décrit dans le premier mode de réalisation (avec une alimentation négative).
Afin de déterminer la présence d'un court-circuit, le dispositif de commande DIGBT comporte de façon connue de l'homme du métier une fonction de détection de court-circuit en interne appelée fonction de détection de saturation DESAT, également couramment appelée fonction desat.
Dans un exemple non limitatif, cette fonction de détection de saturation est implémentée au moyen d'un comparateur de tension interne (non représenté) qui est donc référencé avec ledit potentiel fixe VEE=0V (car le dispositif de commande DIGBT est alimenté entre la masse et le potentiel VPOS) et apte à comparer la tension drain-source Vds dudit transistor à effet de champ JFET avec une tension de référence Vref. Si la tension Vds est supérieure à cette tension Vref, cela signifie que le transistor JFET est en court-circuit.
Comme la tension drain-source Vds est référencée par rapport à la masse qui correspond au même potentiel de référence que celui du comparateur en interne, la comparaison peut se faire sans avoir d'alimentation supplémentaire.

### Deuxième exemple: alimentation entre un potentiel négatif et un potentiel positif

Dans ce mode d'alimentation, dans un deuxième exemple non limitatif, le circuit de commande DRIV comporte en outre un dispositif de commande DIGBT d'un transistor bipolaire à grille isolée IGBT, un inverseur de tension IN couplé audit dispositif de commande DIGBT et un dispositif de décalage de niveau de tension DEN. Ce dispositif de décalage de niveau de tension DEN est couplé à la fonction de désaturation DESAT.

Dans ce deuxième exemple, l'étage amplificateur PSH-PLL est apte à positionner le potentiel de la source S au potentiel fixe VEE pour rendre passant ledit transistor à effet de champ JFET.

Dans cet exemple également, le dispositif de commande DIGBT comporte l'étage amplificateur PSH-PLL tel que décrit précédemment. Dans cet exemple, le dispositif de commande DIGBT d'un transistor bipolaire à grille isolée IGBT est alimenté entre le potentiel négatif VNEG et le potentiel positif VPOS.

On notera que dans le cas d'une alimentation entre un potentiel négatif VNEG et un potentiel positif VPOS, on choisit ces potentiels de manière à ce que le potentiel positif VPOS soit suffisant pour bloquer le transistor JFET, ou de manière à ce que la somme du potentiel négatif VNEG et du potentiel positif VPOS en valeur absolue soit suffisante pour bloquer le transistor JFET.

Comme illustré sur les Fig. 8 et Fig.9, le circuit de commande DRIV comporte une alimentation qui fournit une tension d'alimentation VNEG-VPOS comportant un potentiel positif VPOS et un potentiel négatif VNEG. Le potentiel fixe VEE fourni par l'alimentation du circuit de commande DRIV à la grille G du transistor JFET est positionné au potentiel négatif VNEG. Le potentiel négatif VNEG alimente donc la grille du transistor JFET, soit Ug = VNEG.

On notera que l'inverseur de tension IN est également alimenté par la même tension d'alimentation VNEG-VPOS que le circuit de commande DRIV.

Selon un premier mode de fonctionnement tel qu'illustré sur la Fig. 8, lorsque le premier interrupteur T1 est ouvert, et le deuxième interrupteur T2 est fermé, on a le potentiel de Uo au point de jonction P qui est porté au potentiel négatif VNEG. On obtient donc :
Uo = VEE = VNEG en entrée de l'inverseur IN, soit Us = VPOS en sortie de l'inverseur IN;
Vsg = Us-Ug = VPOS-VNEG, soit Vgs = VNEG-VPOS <0; et
Vds=Ud-Us > 0. La tension Vds sort de l'intervalle de tensions de l'alimentation [VPOS-VNEG].
Le transistor JFET est dans un état bloqué.

Selon un deuxième mode de fonctionnement tel qu'illustré sur la Fig. 9, lorsque le premier interrupteur T1 est fermé, et le deuxième interrupteur T2 est ouvert, on a le potentiel Uo au point de jonction P qui tiré à la masse. On obtient donc :
1) sans le dispositif de décalage de niveau de tension DEN.
   Uo = VPOS en entrée de l'inverseur IN, soit Us = VNEG en sortie de l'inverseur IN;
   Vsg = Us-Ug = VNEG-VNEG = 0V; et
   Vds=Ud-Us > 0 et est donc référencée par rapport au potentiel négatif VNEG car le potentiel Us de source S est positionné au potentiel VNEG.
   La tension Vds appartient à l'intervalle de tensions de l'alimentation [VNEG-VPOS].
2) avec le dispositif de décalage de niveau de tension DEN qui permet de décaler la tension Vds d'une tension égale à la tension VNEG.
   Vds=Ud-Us > 0 et est donc référencée par rapport à la masse.

On a donc la tension Vds comprise dans la gamme de tension [0V ; VPOS].

Dans ce mode de fonctionnement, le transistor JFET est dans un état passant.

Dans cet état passant, il y a des risques de court-circuit sur le transistor JFET, comme décrit dans le premier exemple (avec une alimentation négative).
Afin de déterminer la présence d'un court-circuit, le dispositif de commande DIGBT comporte de façon connu de l'homme du métier la fonction de désaturation DESAT. Dans un exemple non limitatif, cette fonction est implémentée au moyen d'un comparateur de tension interne (non représenté), ledit comparateur étant apte à comparer la tension drain-source Vds dudit transistor à effet de champ JFET avec une tension de référence Vref. Si la tension Vds est supérieure à cette tension Vref, cela signifie que le transistor JFET est en court-circuit.

On notera que dans le cas d'un dispositif de commande DIGBT standard, lorsque celui-ci est alimenté avec un potentiel négatif VNEG et un potentiel positif VPOS, l'émetteur du transistor IGBT qu'il commande est de manière générale relié à la masse et donc le comparateur interne qui implémente la fonction de désaturation DESAT est alimenté avec une tension positive 0V-VPOS pour pouvoir mesurer la tension collecteur-émetteur Vce dudit transistor IGBT pour détecter un court-circuit.

Ainsi, dans le cas de la commande du transistor JFET au moyen du circuit de commande DRIV qui comporte un dispositif de commande DIGBT standard de transistor bipolaire IGBT, le comparateur interne est donc référencé à la masse.

Comme la tension drain-source Vds est référencée par rapport à la masse qui correspond donc au même potentiel de référence que celui du comparateur interne, la comparaison peut se faire sans avoir d'alimentation supplémentaire.

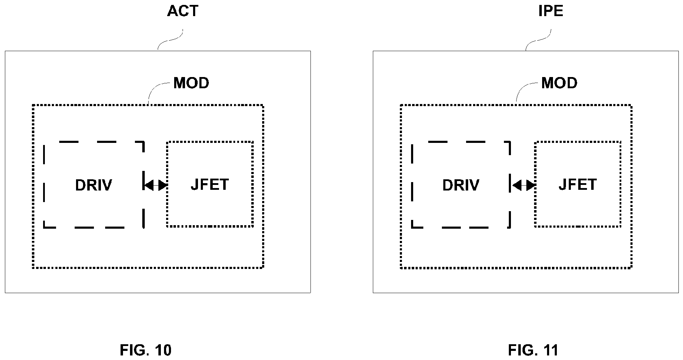

Bien entendu la description n'est pas limitée à l'application, aux modes de réalisation et aux exemples décrits ci-dessus.
- Ainsi, le module électronique de commande MOD peut être utilisé dans tout système faisant appel à la conversion d'énergie. Dans ce cas, le module de commande MOD est un convertisseur électronique de puissance. Dans des modes de réalisation non limitatifs, un actionneur électromécanique ACT peut comprendre un tel convertisseur électronique de puissance tel qu'illustré sur la Fig. 10, ou encore un inverseur de poussée électrique IPE peut comprendre un tel convertisseur électronique de puissance tel qu'illustré sur la Fig. 11, le convertisseur électronique MOD étant utilisé pour commander l'actionneur électromécanique ACT ou l'inverseur de poussée électrique IPE.
   Dans des exemples non limitatifs, un actionneur électromécanique ACT est apte à effectuer la régulation de moteur, à commander des freins, ou encore à commander des vérins VSV « Variable Stator Valve » (couramment utilisés dans des turbines à gaz par exemple).
   Ainsi, le module électronique de commande MOD peut être utilisé notamment mais non exclusivement dans le domaine de l'aviation, de tels actionneurs électromagnétiques et inverseurs de poussée électriques étant couramment utilisés dans ce domaine.
- Ainsi, le circuit de commande DRIV du module électronique de commande MOD peut comporter tout autre dispositif de commande de transistor autre qu'un dispositif de commande DIGBT à transistor bipolaire IGBT, tel qu'un dispositif de commande à transistor MOSFET.
- Par ailleurs, l'étage amplificateur du circuit de commande DRIV peut être un étage « Push-Pull » composé de transistor MOSFET au lieu de transistors bipolaires IGBT.
- L'invention s'applique à tout transistor JFET apte à être commandé en tension négative (Vgs = 0V pour le rendre passant, et Vgs<0V pour le bloquer), quelque soit son matériau de fabrication, tel que dans un exemple non limitatif le Silicium, le Carbure de Silicium, l'Arsénium de Gallium. Ainsi, dans l'exemple non limitatif du JFET, le transistor est un JFET à canal N.
- En outre, dans un mode de réalisation non limitatif, on peut également avoir le potentiel fixe VEE positionné à un potentiel intermédiaire entre le potentiel le plus haut et le potentiel le plus bas fournis par l'alimentation du circuit de commande DRIV. Le potentiel Ug de la grille G du transistor est ainsi fixé à ce potentiel intermédiaire, et on commande le transistor JFET pour le rendre passant avec le potentiel le plus bas et pour le bloquer avec le potentiel le plus haut. Dans ce cas, on choisit le potentiel le plus bas VNEG légèrement supérieur au potentiel intermédiaire, dans un exemple non limitatif égal à 1V, et le potentiel le plus haut VPOS nettement supérieur au potentiel intermédiaire, dans un exemple non limitatif égal à +25V. Dans un exemple non limitatif, on prend le potentiel intermédiaire égal à 0V.
   On notera que ce mode permet de rendre plus passant le transistor JFET.
- Enfin, bien entendu, le module électronique de commande MOD peut comporter un dispositif de protection court-circuit pour le circuit de commande DRIV, dispositif de protection qui est apte à être activé suite à la détection de court-circuit décrite précédemment. Cela permet ainsi de limiter la durée de dissipation d'énergie due à un court-circuit et évite ainsi la destruction du circuit de commande DRIV. Un tel dispositif de protection court-circuit étant connu de l'homme du métier, il n'est pas décrit ici.

Ainsi, l'invention décrite présente notamment les avantages suivants :
- elle est simple à mettre en œuvre;
- avec la commande de la source S du transistor JFET par rapport à la grille G, le fonctionnement en mode bloqué ou passant d'un transistor JFET n'est pas changé par rapport à une commande de l'état de la technique de la grille G dudit transistor JFET : lorsque Vgs = 0 le transistor JFET est passant, et lorsque Vgs<0 le transistor JFET est bloqué;
- elle évite d'avoir une alimentation (isolée) supplémentaire pour la fonction de détection de court-circuit : on a donc une simplification de la conception d'un module électronique de commande. Il n'y a pas d'enroulement supplémentaire (par exemple dans le cas d'alimentation à découpage par transformateur) ni de régulation associée supplémentaire, que ce soit à l'extérieur du circuit de commande ou en interne (le design du circuit de commande étant ainsi simplifié);
- elle permet d'utiliser un dispositif de commande standard utilisé pour commander les transistors bipolaires IGBT ou encore des transistors MOSFET et donc d'utiliser des dispositifs de commande couramment répandus sur le marché :
   - elle permet donc de remplacer facilement l'utilisation d'un transistor bipolaire par un transistor JFET qui présente des avantages supplémentaires par rapport aux transistors bipolaires, tels que l'utilisation à haute température par exemple de 200°. A cet effet, peu d'adaptations sont nécessaires puisqu'il suffit d'ajouter un inverseur (et le cas échéant un dispositif de décalage de niveau de tension) et d'effectuer les connexions adaptées sur la source et sur la grille du transistor JFET; et
   - elle permet donc d'utiliser une fonction de détection de court-circuit couramment intégrée dans les dispositifs de commande d'un transistor IGBT ou d'un transistor MOSFET ; et
- elle permet de proposer une solution pour commander un transistor JFET alternative à l'état de la technique antérieur.

## Revendications

1. Module électronique de commande (MOD) comprenant :
- un transistor à effet de champ (JFET), comprenant une grille (G), un drain (D) et une source (S), dont :
- la grille (G) est connectée à un potentiel fixe (VEE) ; et
- la source (S) est connectée à un étage amplificateur (PSH-PLL) apte à faire varier le potentiel de la source (S) du transistor à effet de champ (JFET) par rapport au potentiel de la grille (G) dudit transistor à effet de champ (JFET)- un circuit de commande (DRIV) comportant :
- une alimentation apte à fournir le potentiel fixe (VEE) à la grille (G) du transistor à effet de champ (JFET) ;
- l'étage amplificateur (PSH-PLL) ;
, ledit module électronique de commande (MOD) dont :
ledit potentiel fixe (VEE) est un potentiel nul et
ledit circuit de commande (DRIV) est alimenté par une tension d'alimentation positive 0V-VPOS comprenant donc un potentiel positif (VPOS), le circuit de commande étant ainsi placé entre la masse et le potentiel positif (VPOS), le potentiel fixe (VEE) fourni par l'alimentation du circuit de commande (DRIV) à la grille (G) du transistor (JFET) est positionné au potentiel le plus bas fourni par l'alimentation, qui est la masse, ledit circuit de commande et comporte en outre :
- un dispositif de commande (DIGBT) pour un transistor bipolaire à grille isolée (IGBT) comportant
- l'étage amplificateur (PSH-PLL) comportant au moins deux transistors placés en série (T1-T2) dans un montage de type push-pull, un des transistors (T2) dudit étage amplificateur comprenant un collecteur (C2) apte à être connecté avec la grille dudit transistor à effet de champ (JFET) et
- une fonction de détection de saturation dans lequel la fonction de détection de saturation est implémentée au moyen d'un comparateur de tension interne référencé avec ledit potentiel fixe (VEE=0V) et apte à comparer la tension drain-source (Vds) dudit transistor à effet de champ (JFET) avec une tension de référence (Vref)
- un dispositif de protection court-circuit pour le circuit de commande DRIV, dispositif de protection qui est apte à être activé suite à la détection de court-circuit par la fonction de détection de saturation ; et
- un inverseur de tension (INV) couplé audit dispositif de commande (DIGBT), ledit inverseur de tension (INV) étant connecté en entrée à un point de jonction commun (P) de l'étage amplificateur (PSH-PLL) et en sortie à la source dudit transistor à effet de champ (JFET), le point de jonction commun (P) étant la sortie de l'étage amplificateur (PSH-PLL), et en ce que l'inverseur de tension (IN) est également alimenté par la même tension d'alimentation positive (0V-VPOS) que le circuit de commande (DRIV),
dans lequel l'étage amplificateur (PSH-PLL) est apte à positionner le potentiel de la source (S) au potentiel fixe (VEE) pour rendre passant ledit transistor à effet de champ (JFET), et
en ce que lorsque le premier interrupteur (T1) est ouvert, et le deuxième interrupteur (T2) est fermé, on a le potentiel de jonction (Uo) au point de jonction (P) qui est tiré à la masse en entrée de l'inverseur (IN), soit la tension positive (VPOS) en sortie de l'inverseur (IN).

2. Module électronique de commande (MOD) selon la revendication précédente, selon lequel le circuit de commande (DRIV) comporte en outre un dispositif de décalage de niveau de tension (DEN).

3. Actionneur électromécanique (ACT), **caractérisé en ce qu'**il comporte un module électronique de commande (MOD) selon l'une quelconque des revendications précédentes.

4. Inverseur de poussée électrique (IPE), **caractérisé en ce qu'**il comporte un module électronique de commande (MOD) selon l'une quelconque des revendications précédentes 1 à 3.

## Patentansprüche

1. Elektronisches Befehlsmodul (MOD), umfassend:
- einen Transistor mit Feldeffekt (JFET), umfassend ein Gitter (G), ein Drain (D) und eine Source (S), deren;
- Gitter (G) an ein festes Potenzial (VEE) angeschlossen ist; und
- die Source (S) an eine Verstärkeretage (PSH-PLL) angeschlossen ist, die geeignet ist, das Potenzial der Source (S) des Transistors mit Feldeffekt (JFET) in Bezug auf das Potenzial des Gitters (G) des genannten Transistors mit Feldeffekt (JFET) zu variieren - wobei ein Befehls-Schaltkreis (DRIV) umfasst:
- eine Versorgung, die geeignet ist, das feste Potenzial (VEE) dem Gitter (G) des Transistors mit Feldeffekt (JFET) zu liefern;
- die Verstärkeretage (PSH-PLL);
wobei das genannte elektronische Befehlsmodul (MOD), dessen genanntes festes Potenzial (VEE) ein Nullpotenzial ist und
der genannte Befehls-Schaltkreis (DRIV) durch eine positive Versorgungsspannung 0V-VPOS versorgt ist, umfassend somit ein positives Potenzial (VPOS), wobei der Befehls-Schaltkreis somit zwischen der Masse und dem positiven Potenzial (VPOS) angeordnet ist, das feste Potenzial (VEE), das von der Versorgung des Befehls-Schaltkreises (DRIV) dem Gitter (G) des Transistors (JFET) geliefert ist, am niedrigsten Potenzial angeordnet ist, das von der Versorgung geliefert ist, das die Masse, der genannte Befehls-Schaltkreis ist und darüber hinaus umfasst:
- eine Befehlsvorrichtung (DIGBT) für einen bipolaren Transistor mit isoliertem Gitter (IGBT), umfassend
- die Verstärkeretage (PSH-PLL), umfassend wenigstens zwei Transistoren, die in Serie (T1-T2) in einer Montage vom Typ Push-Pull angeordnet sind, wobei einer der Transistoren (T2) der genannten Verstärkeretage einen Kollektor (C2) umfasst, der geeignet ist, an das Gitter des genannten Transistors mit Feldeffekt (JFET) angeschlossen zu sein und;
- eine Funktion zur Sättigungserkennung, bei der die Funktion zur Sättigungserkennung mittels eines internen Spannungskomparators implementiert ist, der mit dem genannten festen Potenzial (VEE = 0V) referenziert und geeignet ist, die Drain-Source-Spannung (Vds) des genannten Transistors mit Feldeffekt (JFET) mit einer Referenzspannung (Vref) zu vergleichen;
- eine Schutzvorrichtung gegen Kurzschluss für den Befehls-Schaltkreis DRIV, wobei die Schutzvorrichtung geeignet ist, im Anschluss an die Entdeckung des Kurzschlusses durch die Funktion zur Sättigungserkennung aktiviert zu sein; und
- einen Spannungsumschalter (INV), der an die genannte Befehlsvorrichtung (DIGBT) gekoppelt ist, wobei der genannte Spannungsumschalter (INV) am Eingang an einem gemeinsamen Verbindungspunkt (P) der Verstärkeretage (PSH-PLL) und am Ausgang an der Source des genannten Transistors mit Feldeffekt (JFET) angeschlossen zu sein, wobei der gemeinsame Verbindungspunkt (P) der Ausgang der Verstärkungsetage (PSH-PLL) ist und dass der Spannungsumschalter (IN) ebenfalls durch dieselbe positive Versorgungsspannung (0V - VPOS) wie der Befehls-Schaltkreis (DRIV) versorgt ist,
bei dem die Verstärkeretage (PSH-PLL) geeignet ist, das Potenzial der Source (S) am festen Potenzial (VEE) anzuordnen, um den genannten Transistor mit Feldeffekt (JFET) durchlässig zu machen, und
dass, wenn der erste Schalter (T1) offen ist und der zweite Schalter (T2) geschlossen ist, das Verbindungspotenzial (Uo) am Verbindungspunkt (P) vorhanden ist, das aus der Masse am Eingang des Umkehrschalters (IN) abgezogen ist, d. h. die positive Spannung (VPOS) am Ausgang des Umkehrschalters (IN).

2. Elektronisches Befehlsmodul (MOD) gemäß dem voranstehenden Anspruch, gemäß dem der Befehlsschaltkreis (DRIV) darüber hinaus eine Versetzungsvorrichtung des Spannungsniveaus (DEN) umfasst.

3. Elektromechanisches Stellglied (ACT), **dadurch gekennzeichnet, dass** es ein elektronisches Befehlsmodul (MOD) gemäß irgendeinem der voranstehenden Ansprüche umfasst.

4. Elektrischer Schubumschalter (IPE), **dadurch gekennzeichnet, dass** er ein elektronisches Befehlsmodul (MOD) gemäß irgendeinem der voranstehenden Ansprüche 1 bis 3 umfasst.

## Claims

1. An electronic control module (MOD) comprising :
a. a field effect transistor (JFET) comprising a gate (G), a drain (D) and a source (S), A field effect transistor (JFET) whose:
i. Gate (G) is connected to a fixed potential (VEE) ; and
ii. Source (S) is connected to said amplifier stage (PSH-PLL) adapted to vary the potential of the source (S) of the field effect transistor (JFET) with relation to the potential of the gate (G) of said field effect transistor (JFET)
b. A control circuit (DRIV) comprising:
- a power supply that is able to provide a fixed potential (VEE) to the gate (G) of the field effect transistor (JFET) ; and
- an amplifier stage (PSH-PLL);
the electronic control module (MOD) whose :
- said fixed potential (VEE) is a negative potential
- said control circuit (DRIV) is supplied by a positive power supply voltage 0V-VPOS comprising thus comprising a positive potential (VPOS), said control circuit (DRIV), the control circuit thus being placed between the ground and the positive potential (VPOS), the fixed potential (VEE) provided by the power supply of the control circuit (DRIV) to the gate (G) of the transistor (JFET) is positioned at the lowest potential provided by the power supply, which is the ground, said control circuit (DRIV) furthermore comprising :
∘ a control device (DIGBT) for an insulated gate bipolar transistor (IGBT) comprising :
▪ the amplifier stage (PSH-PLL) comprising at least two at least two transistors placed in series (T1-T2) in a push-pull type assembly, one of the transistors (T2) of said amplifier stage comprising a collector (C2) that is able to be connected with the gate of said field effect transistor (JFET) and
▪ a saturation detection function wherein the saturation detection function is implemented by means of an internal voltage comparator that is thus referenced with said fixed potential (VEE=0V) and able to compare the drain to source voltage (Vds) of said field effect transistor (JFET) with a reference voltage (Vref)
▪ a short circuit protection device for the control circuit (DRIV), the protection device that is able to be activated following detection of a short circuit by the saturation detection function; and
∘ a voltage inverter (IN) coupled to said control device (DIGBT), said voltage inverter (IN) being connected in input to a common junction point (P) of the amplifier stage (PSH-PLL) and in output to the source of said field effect transistor (JFET), the common junction point (p) being the output of the amplifier stage (PSH-PLL), and in that the voltage inverter (IN) is also supplied by the same positive power supply voltage (0V-VPOS) as the control circuit (DRIV),
▪ wherein the amplifier stage (PSH-PLL)) is able to position the potential of the source (S) to the fixed potential (VEE) to switch on said field effect transistor (JFET), and
∘ in that when the first switch (T1) is open, and the second switch (T2) is closed, one has the junction potential Uo at the junction point P that is drawn to ground in input of the inverter (IN), i.e the positive potential (VPOS) in output of the inverter (IN).

2. The electronic control module (MOD) according to the previous claim, wherein the control circuit (DRIV) further comprises a voltage level shift device (DEN).

3. An electromechanical actuator (ACT), **characterized in that** the actuator comprises an electronic control module (MOD) according to any one of the previous claims.

4. An electric thrust reverser (IPE), **characterized in that** the reverser comprises an electronic control module (MOD) according to any one of the previous claims 1 to 3.
